# EUROPEAN PATENT SPECIFICATION

(11) **EP 4 404 463 B1**
(45) Date of publication and mention of the grant of the patent: **18.03.2026**
(21) Application number: 22800308.3
(22) Date of filing: 12.09.2022
(51) Int. Cl.: H03K 17/12, G05F 1/20, H01F 29/04

(54) **STATIC AC SWITCH WITH EXTENDED CURRENT RANGE**
STATISCHER WECHSELSTROMSCHALTER MIT ERWEITERTEM STROMBEREICH
INTERRUPTEUR STATIQUE DE COURANT ALTERNATIF À PLAGE D'INTENSITÉ ÉTENDUE

(30) Priority: 14.09.2021 ES 202130853
(43) Date of publication of application: 24.07.2024
(73) Proprietor: Universidad De Sevilla, 41013 Sevilla (ES)
(72) Inventor: MAZA ORTEGA, José María, 41013 Sevilla (ES); DE PAULA GARCÍA LÓPEZ, Francisco, 41013 Sevilla (ES); BARRAGÁN VILLAREJO, Manuel, 41013 Sevilla (ES)
(74) Representative: Pons IP
(86) International application number: PCT/ES2022/070569
(87) International publication number: WO 2023/041825

(56) References cited:
- CN-B- 103 781 258
- US-B2- 6 590 349

## Description

### OBJECT OF THE INVENTION

It concerns a static AC switch with extended current range, for a static on-load tap changer in power transformers, based on the parallelisation of thyristors, which enables current to be conducted safely and autonomously over a wide range, from no-load to short-circuit currents, with respect to that of a single thyristor.

### BACKGROUND OF THE INVENTION

Transformers, located in transformation centres, are massively used in electrical power distribution networks to reduce voltage levels from medium (usually 20 kV) to low (usually 400 V). These transformers are equipped with a fixed tap changer that allows the voltage on the low voltage side to be regulated, although it cannot be operated on load. Practically, the tap is adjusted at the time of installation of the transformer and is left in said position permanently for the entire useful life thereof.

However, the transformation of said distribution networks towards future smart networks in which a massive presence of distributed generation and new agents, such as the electric car, is expected, makes it necessary to dynamically improve low-side voltage regulation, in order to which on-load tap-changers are required.

On-load tap changers are widely used for large power transformers used in high voltage networks, although they are not conventional for distribution transformers. These are electromechanical devices characterised by being complex, bulky, with a limited number of manoeuvres and slow actuation times. For this reason, this conventional solution cannot be applied to distribution power transformers.

In response to this need, tap changer technologies have been developed that are specially adapted to the characteristics of distribution transformers, among which those corresponding to the use of no-load switches and power electronic devices stand out.

By way of example, patent documents CN 1 03781258B and US6590349B2 can be found.

The first patent document discloses a light adjusting circuit and an illumination control apparatus that uses the light adjusting circuit. The light adjusting circuit comprises a first controllable switch, a control signal input end connected with the control end of the first controllable switch, a first connecting end, a resistor R1, a second connecting end and a second controllable switch, wherein the other two ends of the first controllable switch are respectively connected with the first connecting end and connected with the second connecting end through the resistor R1; the control end of the second controllable switch is connected with the second connecting end through the resistor R1, and the other two ends of the second controllable switch are connected with the first connecting end and the second connecting end respectively. A chopping signal generated by a controller controls the breakover time of the first controllable switch with the smaller rated power, and therefore controls the luminescence of a lighting lamp connected to the second connecting end to be changed. When the voltage loaded on the control end of the second controllable switch reaches the breakover voltage, the second controllable switch with the larger rated power is broken over and becomes access of an alternating current, and therefore the large-power and small-power working requirements of the lighting lamp can be met.

The second patent document discloses a bidirectional switch that includes a first bidirectional switch between two power terminals of the switch, a low-voltage storage element between a first power terminal and a control terminal of the switch, and a control stage adapted to cause, upon each halfwave beginning of an A.C. supply voltage applied between the power terminals and when the switch is on, the charge of the storage element with a biasing depending on the sign of the halfwave.

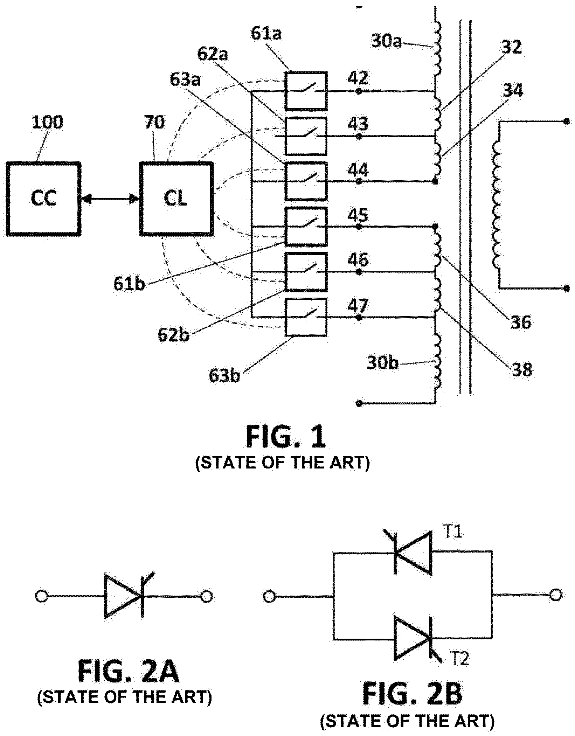

Furthermore, also by way of example, within the first group patent documents of interest such as WO2013156268A1 and EP3288053A1 can be found. From the second, document ES2734601 B2 "Static on-load tap changer for transformers with discontinuous regulating windings" is known, which describes a specific configuration of static tap changers for power transformers that is detailed in figure 1. The topology combines a series of static switches (61a, 62a, 63a, 61b, 62b and 63b) especially suited for the configuration of windings (main 30a, 30b and regulation 32, 34, 36 and 38) that minimises the number thereof. Said static switches can be made by means of different configurations of electronic devices that allow bidirectional current conduction and also have a bidirectional blocking capacity.

The use of thyristors (like the one in figure 2A) with anti-parallel configuration, like the ones shown in figure 2B, is a known technical solution that is suited to the application due to the low losses thereof. This configuration is formed by two identical thyristors (T₁ and T₂) that are connected in anti-parallel to allow the bidirectional current flow required in AC applications.

However, there is no anti-parallel thyristor configuration on the market that is fully compatible with the technical requirements of the on-load tap-changer application for distribution transformers:
i) High blocking voltages, since the tap changer is connected to the medium voltage side of the transformer where the regulating windings are usually located.
ii) High short-time current, to be able to withstand possible short-circuit currents.
iii) Reduced blocking currents (*latching*)*,* to be able to operate reliably at low load or even with no-load.

This last aspect is of vital importance today because, with the current European guidelines on the efficient design of transformers (in particular (EU) Regulation No 548/2014 of the Commission of 21 May 2014, which develops Directive 2009/125/EC of the European Parliament and of the Council with regard to small, medium and large power transformers), no-load currents are increasingly reduced.

### DESCRIPTION OF THE INVENTION

The object of the present invention is a static AC switch with extended current range as defined in the appended claims. It is based on the association of thyristors which:
i) Allows the bidirectional circulation of currents required for AC applications. For this, the association of thyristors of the proposed switch topology comprises a first set of thyristors (T_{H1} and T_{L1}) connected in parallel and a corresponding second set of thyristors (T_{H2} and T_{L2}) connected in parallel with identical characteristics, connected in anti-parallel to the first set of thyristors (T_{H1} and TL1).
ii) Allows the circulation of a wide range of currents. To do this, two thyristors (T_{H1} and T_{L1}), and the corresponding anti-parallel ones in the second set of thyristors (T_{H2} and T_{L2}), the thyristors of each set being of different rated currents (*Iₙ*), such that the rated current of a first thyristor of each set of thyristors is greater than the rated current of a second thyristor of each set of thyristors (*I*_{*nH*1} *> I*_{*nL*1} and *I*_{*nH*2} > *I*_{*nL*2})*.* Given this ratio between rated currents, the blocking currents (*Iₗ*) in each set of thyristors will fulfill that *I*_{*lH*1} *> I*_{*lL*1} and *I*_{*lH*2} > *I*_{*lL*2}*.*

The topology of the proposed switch is applicable in those cases in which the minimum current to conduct, *Iₘᵢₙ*, is lower than the blocking current of the thyristors with higher rated current of each set of thyristors (T_{H1} and T_{H2}), that is *I*_{*lH*1}*, Il*_{*H*2} > *Iₘᵢₙ.* In particular, note that at currents *I < I*_{*lH*1}*, I*_{*lH*2}*,* there would be no effective conduction of the thyristors with higher rated current (T_{H1} and T_{H2}) of each set of thyristors.

The proposed topology, therefore, has the following operating principle:
i) when the circulating current is very low, this is *I < I*_{*lH*1}*, I*_{*lH*2}*,* conduction is ensured by the thyristors with lower rated current (T_{L1} and T_{L2}) of each set of thyristors, provided that the following is met *I > I*_{*lL*1}*, I*_{*lL*2}*,*
ii) when the current is above a threshold, which is *I > I*_{*lH*1} *I*_{*lH*2}*,* conduction is carried out exclusively by the thyristors with higher rated current (T_{H1} and T_{H2}) of each set of thyristors.

In this sense, the selection of the thyristors is of vital importance to achieve an operation such as that described in the previous points. Particularly, in the case of static on-load tap-changers for distribution transformers, the lowest current to be conducted corresponds to the no-load current of the transformer, *I*₀, so that the switches with lower rated current (T_{L1} and T_{L2}) of each set of selected thyristors must verify that *I*₀ *< I*_{*lL*1} *I*_{*lL*2}.

In particular, the topology of the static AC switch object of the invention comprises:
i) two terminals (A and B), intended to be connected to any external AC circuit in which it is required to control the current,
ii) a first thyristor with lower rated current (T_{L1}), and the corresponding anti-parallel thyristor (T_{L2}) thereof of identical characteristics, each of the thyristors with lower rated current comprising an anode, a cathode and a gate,
iii) two conventional trigger circuits (CD_{C1} and CD_{C2}) connected to the thyristors with lower rated current (T_{L1} and T_{L2}) through the gates thereof. The conventional trigger circuit can be based on any of the techniques commonly used for thyristors (pulse transformers, opto-coupling or using the anode voltage),
iv) a control device connected to the conventional trigger circuit, which will operate the thyristors with lower rated current (T_{L1} and T_{L2}),
v) a first thyristor with higher rated current (T_{H1}), and the corresponding anti-parallel thyristor with higher rated current (T_{H2}), with identical characteristics, each of the thyristors with a higher rated current (T_{H1} and T_{H2}) comprising an anode, a cathode and a gate,
vi) two tri-terminal trigger circuits (CD1 and CD₂), connected to the gates of the thyristors with higher rated current (T_{H1} and T_{H2}), and which are specifically intended to achieve the performance described above.

The proposed invention has advantages in relation to the current state of the art, since it achieves the formation of a static switch from a set of thyristors with different characteristics, which extends the operating range with respect to that of the individual thyristors that make it up, based on an asymmetrical distribution of the current through the thyristors that are parallelised.

Thus, the static switch can be directly applied to static on-load tap changers for distribution transformers with reliable and safe switching with currents in a very wide range, which covers from no-load to short-circuit. Therefore, this invention solves the problem of the current static tap changers for power transformers, which can present operating problems in reduced current ranges (in the environment of the no-load current).

The invention can be applied to medium/low voltage distribution transformers used in the following fields:
- Electric power distribution networks. Transformers belonging to electric companies that are required to supply customers connected at low voltage levels.
- Private customers with their own transformer that are directly connected at medium voltage.
- Photovoltaic inverter transformers coupled at medium voltage.
- Wind turbines.
- Inverter transformers that are connected to power storage devices.

### DESCRIPTION OF THE DRAWINGS

To complement the description that is being made and for the purpose of helping to better understand the features of the invention according to a preferred practical exemplary embodiment thereof, a set of drawings is attached as an integral part of said description in which the following is depicted in an illustrative and non-limiting manner:
Figure 1.- shows a topology of a tap changer for power transformers of the state of the art.
Figure 2.- shows static switches of the state of the art: (a) thyristor-based direct current (DC); (b) anti-parallel thyristor-based alternating current (AC).
Figure 3.- shows a topology with two thyristors with different rated current and tri-terminal trigger circuit proposed that operates on the thyristor with higher rated current: (a) static DC switch; (b) static AC switch.
Figure 4.- shows a possible tri-terminal trigger circuit that operates following the operating principle proposed.
Figure 5.- Current circulation in the case of *I < I*_{*H*1}*_{-L}.*
Figure 6A.- Current circulation in the case of *I* ≥ *I*_{*H*1}*_{-L},* step 1.
Figure 6B.- Current circulation in the case of *I* ≥ *I*_{*H*1}*_{-L},* step 2.
Figure 6C.- Current circulation in the case of *I* ≥ *I*_{*H*1}*_{-L},* step 3.

### PREFERRED EMBODIMENT OF THE INVENTION

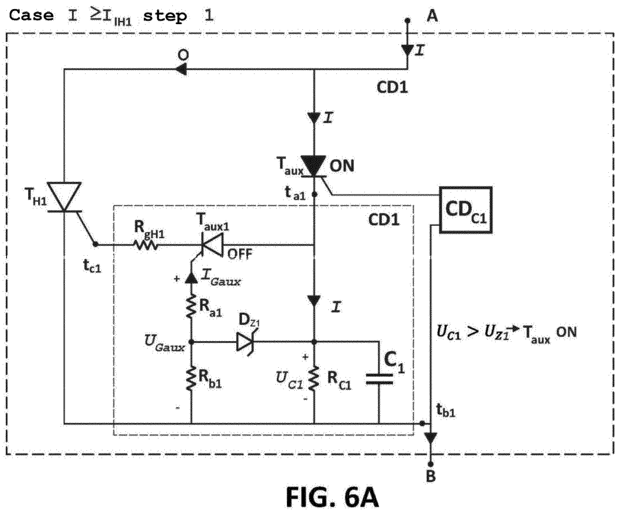

With the help of Figures 1 to 6C, a preferred embodiment of the AC static switch with extended current range, object of the present invention, is described below being of possible use for a static on-load tap changer of power transformer as shown in Figure 1. However, its application is not limited to this case, the use thereof being able to be extended to any other alternative topology.

The highest voltage winding of the transformer, as shown in Figure 1, comprises a main winding (coils 30a and 30b) and a regulating winding (coils 32, 34 and 36, 38). The coils of the regulating winding are accessible through the electrical terminals (42, 43, 44 and 45, 46, 47). A set of static switches (61a, 62a, 63a and 61b, 62b, 63b) are connected to said electrical terminals as the object of the present invention, static switches that are controlled through a local control module (70).

In the case of multi-phase applications, there is an additional central control (100) that supervises the operation of each phase and sends the appropriate instructions to the local controllers. The actuation (on or off) of the static switches (61a, 62a, 63a and 61b, 62b, 63b) establishes the active regulating coils at each moment, so that the transformation ratio of the transformer and therefore, the secondary voltage, is dynamically controlled.

Each of the static switches (61a, 62a, 63a and 61b, 62b, 63b) shown in Figure 1 can be configured as shown in Figure 2B with two anti-parallel connected thyristors (T1, T2) having capacity for bidirectional current driving. However, as has been shown in the background of the invention, for the blocking voltages that are required in the application, there are no thyristors that cover the entire current range associated with the operation of the transformers (no-load current to short circuit current).

The present invention proposes a static switch topology wherein a first set of thyristors are parallelised, (T_{H1} and T_{L1}), and the corresponding second set of anti-parallel thyristors, (T_{H2} and T_{L2}) thereof, with identical characteristics and which verify that their rated currents are such that *I*_{*nH*1} *> I*_{*nL*1} and *I*_{*nH*2} > *I*_{*nL*2}*.* Each of the sets of thyristors comprises a thyristor with higher rated current (T_{H1} and T_{H2}), and a thyristor with lower rated current (T_{L1} and T_{L2}), respectively.

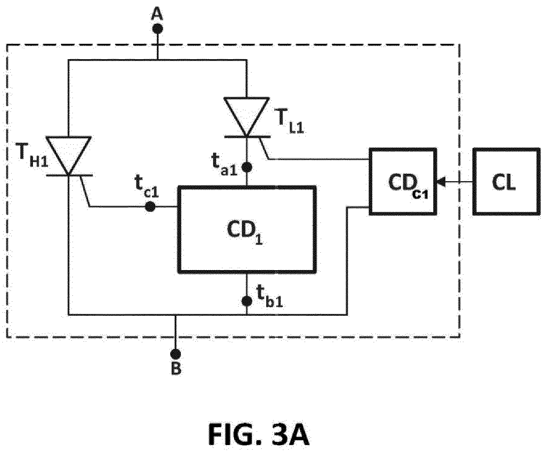

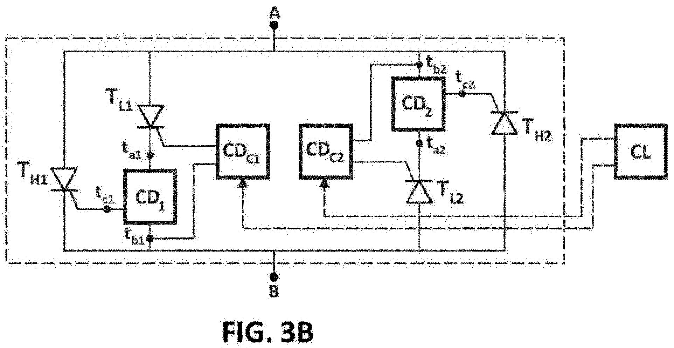

This parallelisation, shown in Figure 3A for the DC version from which the AC version of Figure 3B is formed, achieves the conduction of currents below the blocking current of the thyristors with higher rated current (T_{H1} and T_{H2}), through the thyristors with lower rated current (T_{L1} and T_{L2}), for which it is crucial to carry out an adequate design of tri-terminal trigger circuits (CD₁ and CD₂) linked to the thyristors. The interconnection of all these components that represents a preferred embodiment of the invention is shown in Figure 3B.

In particular, as shown in Figure 3B, the static switch comprises:
i) A first thyristor with lower rated current (T_{L1}), and the corresponding second thyristor with lower rated current (T_{L2}) thereof connected in anti-parallel and with identical characteristics, the thyristors comprising an anode, a cathode and a gate.
ii) A first and a second conventional trigger circuits (CD_{C1} and CD_{C2}) of the thyristors with lower rated current (T_{L1} and T_{L2}), the conventional trigger circuits (CD_{C1} and CD_{C2}) being connected to the thyristors with lower rated current (T_{L1} and T_{L2}) through the corresponding gates thereof.
iii) A control device (CL) connected to the conventional trigger circuits (CD_{C1} and CD_{C2}), the objective of which is to define the status (on or off) of the thyristors with lower rated current (T_{L1} and T_{L2}), and therefore of the static AC switch object of the invention.
iv) A first thyristor with higher rated current (T_{H1}), and a second thyristor with higher rated current (T_{H2}) connected in anti-parallel, with identical characteristics, the thyristors comprising an anode, a cathode and a gate.
v) A first and a second tri-terminal trigger circuits (CD₁ and CD₂), respectively connected to the gates of the thyristors with higher rated current (T_{H1} and T_{H2}).

As shown in Figure 3B, the anodes of the thyristors of the first set of thyristors (T_{H1} and T_{L1}) are connected to the same first terminal (A), which is a first connection terminal of the static switch object of the invention. The anodes of the thyristors of the second set of thyristors (T_{H2} and T_{L2}) are connected to the same second terminal (B) and form the second connection terminal of the static switch object of the invention.

Tri-terminal trigger circuits (CD₁ and CD₂) are connected to the following points respectively: first terminals (tₐ₁ and tₐ₂) to the cathodes of the thyristors with lower rated current (T_{L1} and T_{L2}) respectively; second terminals (t_{b1} and t_{b2}) to the cathodes of the thyristors with higher rated current (T_{H1} and T_{H2}) respectively; finally third terminals (t_{c1} and t_{c2}) to the gates of the thyristors with higher rated current (T_{H1} and T_{H2}) respectively.

Conventional trigger circuits (CD_{C1} and CD_{C2}) are connected to the gate of the thyristors with lower rated current (T_{L1} and T_{L2}) and the second terminals (t_{b1} and t_{b2}) of the tri-terminal trigger circuits (CD₁ and CD₂) respectively.

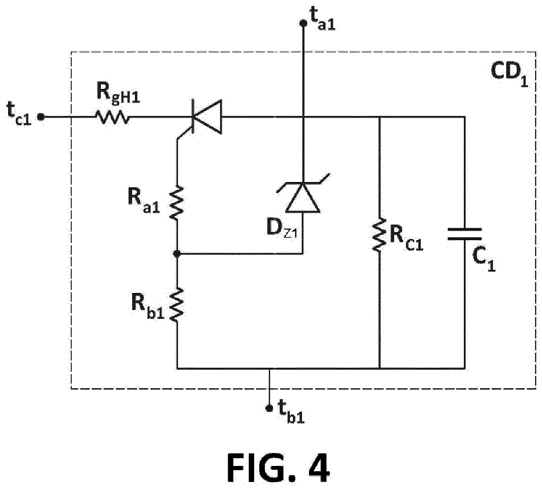

For its part, Figure 4 shows a preferred embodiment of the tri-terminal trigger circuits (CD₁ and CD₂). The first tri-terminal trigger circuit (CD₁) comprises the following components, the second tri-terminal trigger circuit (CD₂) being identical:
i) a capacitor (C₁), connected between the first terminal (tₐ₁) and the second terminal (t_{b1}).
ii) a resistor (R_{c1}), connected between the first terminal (tₐ₁) and the second terminal (t_{b1}) and in parallel with the capacitor (C₁).
iii) an auxiliary thyristor (Tₐᵤₓ₁) connected between the first terminal (tₐ₁) and the third terminal (t_{c1}) with a series resistor (R_{gH1}),
iv) a voltage divider comprising resistors (Rₐ₁ and R_{b1}) connected to the gate of the auxiliary thyristor (Tₐᵤₓ₁) and to the second terminal (t_{b1}),
v) a zener diode (D_{z1}), connected between the first terminal (tₐ₁) and the midpoint of the voltage divider.

This trigger circuit has the mission of causing the triggering of the thyristor with higher rated current, (T_{H1} or T_{H2}), when the current circulating through the static switch is greater than the blocking current thereof, thus ensuring its proper conduction.

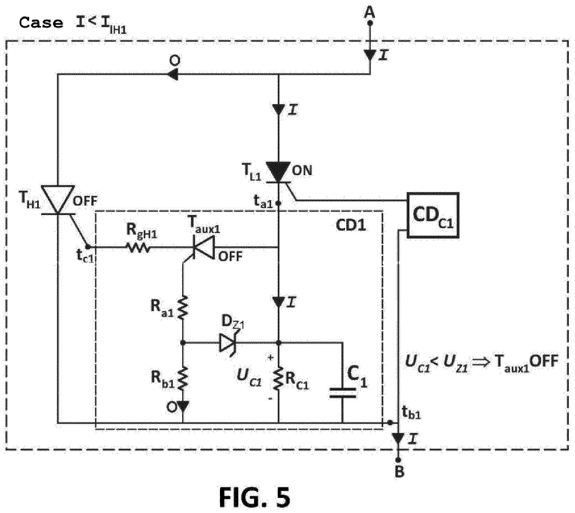

The different modes of operation of the invention are explained in the case of a positive current conduction from the first terminal (A) to the second terminal (B) of the static switch, for which reason the thyristors of the first set (T_{H1}, T_{L1}) and the first tri-terminal trigger circuit (CD₁) are involved in said explanation. The operation for the opposite direction of current circulation is identical, but with the anti-parallel components of the second set of thyristors (T_{H2}, T_{L2}) and the second tri-terminal trigger circuit (CD₂). The configuration of the tri-terminal trigger circuits, (CD₁ and CD₂), allow operation according to the following operating principle depending on the current circulating through the static switch:
i) Current lower than the blocking current of the thyristor with higher rated current (T_{H1}) (*I < I*_{*lH*1}), which is shown in Figure 5. Said current would be conducted through the thyristor with lower rated current (T_{L1}) entering the tri-terminal trigger circuit (CD₁) through the first terminal (tₐ₁). The configuration of the trigger circuit is such that the outgoing current through the third terminal (t_{c1}) is zero to prevent the triggering of the thyristor with higher rated current (T_{H1}) that could not maintain its conduction because the circulating current was lower than the blocking current thereof. Therefore, the outgoing current through the second terminal (t_{b1}) is identical to the incoming current through the first terminal (tₐ₁), conduction being ensured by the switch with lower rated current (T_{L1}).
ii) Current equal to or greater than the blocking current of the thyristor with higher rated current T_{H1} (*I* ≥ *I*_{*lH*1}), as shown in Figures 6A to 6C. As in the previous case, the current would begin to flow through the thyristor with lower rated current (T_{L1}), entering the trigger circuit (CD₁) by the first terminal (tₐ₁). However, because the conditions are met for the thyristor with higher rated current (T_{H1}) to have proper conduction, the triggering is carried out. For this, the design of the tri-terminal circuit (CD₁) is such that it guarantees a certain outgoing current *I_{Gaux}* at the third terminal (t_{c1}) (gate current of the thyristor with higher rated current (T_{H1})) and a voltage *U_{Gaux}* between the third terminal (t_{c1}) and the second terminal (t_{b1}) (gate-cathode voltage of the thyristor with higher rated current (T_{H1})) that cause the triggering of said thyristor. In this case, and until the triggering of the first thyristor with higher rated current (T_{H1}) is produced, the outgoing current of the first terminal (t_{b1}) will be the difference between the incoming current through the first terminal (tₐ₁) and the outgoing current through the third terminal (t_{c1}). From the moment in which the thyristor with higher rated current (T_{H1}) begins to conduct, the current through the thyristor with lower rated current (T_{L1}) is cancelled.

The first mode of operation, in which the current *I* is lower than the blocking current of a thyristor with higher rated current (T_{H1}) (*I < I*_{*lH*1}) and greater than the blocking current of the thyristor with lower rated current T_{L1} (*I < I*_{*lL*1}), is illustrated in Figure 5. Note that, for the proper operation of the static switch object of the invention, the minimum expected current must be greater than the blocking current of the thyristor with lower rated current (T_{L1}) (*Iₘᵢₙ > I*_{*lL*1}). In the case of using the static switch for static changers of power transformers, therefore, the thyristor with lower rated current (T_{L1}) must be selected so that it can conduct no-load current of the transformer, *Iₒ*, which is the minimum possible current, so that *Iₒ > I*_{*lL*1}*.* In this case, the current would circulate through the thyristor with lower rated current (T_{L1}). Note that the current would be circulating through the set formed by the capacitor (C₁) and the resistor (R_{c1}), which would be subjected to a tension *U_{C1}* as shown in Figure 5. The values of the capacitor (C₁) and the resistor (R_{c1}) are adjusted such that the voltage *U*_{*C*1} is lower than the avalanche voltage of the zener diode (D_{z1}) so that it does not conduct at currents lower than *I*_{*lH*1}*.* Therefore, the reduced current is conducted through the thyristor with lower rated current (T_{L1}) and the triggering of the thyristor with higher rated current (T_{H1}), due to the fact that the auxiliary thyristor (Tₐᵤₓ₁) is not triggered.

In the second operating mode, the current is greater than or equal to the blocking current of the thyristor with the higher rated current (T_{H1}) (*I* ≥ *I*_{*lH*1})*,* being able to ensure its proper conduction. The triggering process of said thyristor (T_{H1}) follows the steps below. First, given the current *I* circulating, a voltage is generated in the capacitor (C₁) such that the action of the zener diode (D_{z1}) that causes current to flow through the gate of the auxiliary thyristor (Tₐᵤₓ₁) is produced, as shown in Figure 6A. Note that the resistors (Rₐ₁ and R_{b1}) form a current divider, so that in order to maximise the current to the gate of the auxiliary thyristor (Tₐᵤₓ₁), resistors must be selected fulfilling that Rₐ₁/Rₚ₁<<1. In particular, the triggering of the auxiliary thyristor (Tₐᵤₓ₁) will be produced if the voltage and current, *U_{Gaux}* and *I_{Gaux},* at the gate of the auxiliary thyristor (Tₐᵤₓ₁) and shown in Figure 6A, are higher than the gate voltages and gate current of (Tₐᵤₓ₁) that guarantee the triggering thereof.

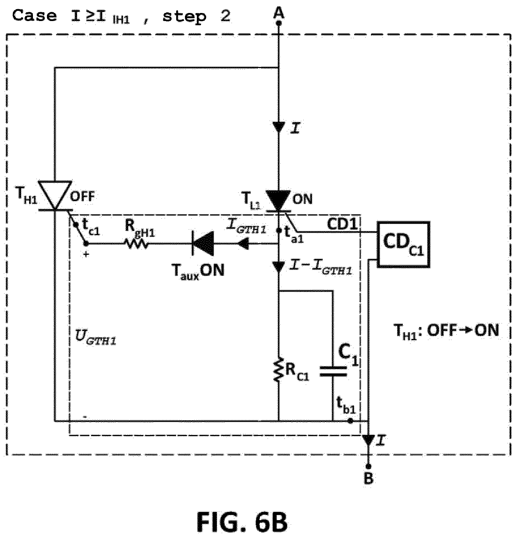

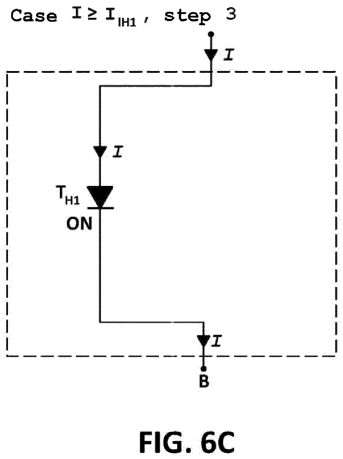

As a consequence of the triggering of the auxiliary thyristor (Tₐᵤₓ₁) the circuit shown in Figure 6B would result. So, the auxiliary thyristor (Tₐᵤₓ₁) feeds the gate of the thyristor with higher rated current (T_{H1}), so that it will be triggered as long as the conditions for it are met. In particular, in the same way as in the case of the auxiliary thyristor (Tₐᵤₓ₁), it must be verified that *U*_{*GT*_{*H*1}} and *I*_{*GT*_{*H*1}} are greater than the corresponding voltage and current values of gate triggering for said thyristor. In this case, the triggering of the thyristor with higher rated current (T_{H1}) will be produced, so that the current would be exclusively conducted by this thyristor, as shown in Figure 6C.

## Claims

1. -A static AC switch with extended current range, comprising:
i) a first terminal (A) and a second terminal (B), intended to be connected to any external AC circuit in which current control is required,
iii) a first set of two thyristors (T_{L1} and T_{H1}) such that the rated currents thereof follow *I*_{*nH*1} *> I*_{*nL*1}*,* which are connected in parallel to each other, each comprising an anode, a cathode and a gate, the anodes being connected to the first terminal (A),
iii) a second set of two thyristors (T_{L2} and T_{H2}) such that the rated currents thereof follow *I_{nH2}* > *I*_{*nL*2}*,* which are connected in parallel to each other and anti-parallel with respect to the first set of thyristors (T_{L1} and T_{H1}), each comprising an anode, a cathode and a gate, and the anodes being connected to the second terminal (B),
iv) trigger circuits (CD_{C1} and CD_{C2}) connected to the gates and cathodes of the thyristors with lower rated current (T_{L1} and T_{L2}) respectively, to generate the triggering of the same,
v) a control device (CL) connected to the trigger circuits (CD_{C1} and CD_{C2}),
vi) tri-terminal trigger circuits (CD₁ and CD₂) that manage the triggering of the thyristors with higher rated current, (T_{H1} and T_{H2}), and comprising, respectively:
i) first terminals (tₐ₁ and tₐ₂) connected to the cathodes of the thyristors with lower rated current (T_{L1} and T_{L2}) respectively,
ii) second terminals (t_{b1} and t_{b2}) connected to the cathodes of the thyristors with higher rated current (T_{H1} and T_{H2}), respectively, and
iii) third terminals (t_{c1} and t_{c2}) connected to the gate of the thyristors with higher rated current (T_{H1} and T_{H2}),
wherein, the tri-terminal trigger circuits (CD₁ and CD₂) are configured to:
• when the circulating current through the static switch is lower than the blocking current of the thyristor with higher rated current (T_{H1}, T_{H2}), this is *I < I*_{*lH*1}, *I*_{*lH*2}, allow current conduction by the thyristors with lower rated current (T_{L1} and T_{L2}), blocking current through the third terminals (t_{c1} and t_{c2}), wherein the blocking current is the minimum current that could maintain conduction of said thyristor, and
• when the circulating current through the static switch is higher than the blocking current of the thyristor with higher rated current (T_{H1}, T_{H2}), this is *I > I*_{*lH*1}*,I*_{*lH*2}, feed the gate of the thyristor with higher rated current (T_{H1} and T_{H2}) through the third terminal (t_{c1} and t_{c2}), causing the triggering of said thyristor when a gate current (*I_{Gaux}*) of the thyristor with higher rated current (T_{H1} and T_{H2}) and a gate-cathode voltage (*U_{Gaux}*) of the thyristor with higher rated current (T_{H1} and T_{H2}), between the third terminal (t_{c1} and t_{c2}) and the second terminal (t_{b1} and t_{b2}), are greater than the gate voltage and current triggering values of the thyristor with higher rated current (T_{H1} and T_{H2}); and once the triggering is carried out, allow current conduction by the thyristor with higher rated current (T_{H1} and T_{H2}) through the third terminals (t_{c1} and t_{c2}).

2. The static switch of claim 1, wherein each of the tri-terminal trigger circuits (CD₁ and CD₂) comprises:
i) a capacitor (C₁), connected between the first terminal (tₐ₁) and the second terminal (t_{b1}),
ii) a resistor (R_{c1}), connected between the first terminal (tₐ₁) and the second terminal (t_{b1}) and in parallel with the capacitor (C₁),
iii) an auxiliary thyristor (Tₐᵤₓ₁) connected between the first terminal (tₐ₁) and the third terminal (t_{c1}) with a series resistor (R_{gH1}),
iv) a voltage divider comprising resistors (Rₐ₁ and R_{b1}), connected to the gate of the auxiliary thyristor (Tₐᵤₓ₁) and to the second terminal (t_{b1}),
v) a zener diode (D_{z1}), connected between the first terminal (tₐ₁) and a midpoint of the voltage divider.

## Patentansprüche

1. Statischer Wechselstromschalter mit erweitertem Strombereich, umfassend:
i) eine erste Klemme (A) und eine zweite Klemme (B), die dazu bestimmt sind, an einen beliebigen externen Wechselstromkreis angeschlossen zu werden, in dem eine Stromsteuerung erforderlich ist,
iii) einen ersten Satz von zwei Thyristoren (T_{L1} und T_{H1}), so dass deren Nennströme *I*_{*nH*1} *> I*_{*nL*1} folgen, die parallel zueinander angeschlossen sind und jeweils eine Anode, eine Kathode und ein Gate umfassen, wobei die Anoden an die erste Klemme (A) angeschlossen sind,
iii) einen zweiten Satz von zwei Thyristoren (T_{L2} und T_{H2}), so dass deren Nennströme *I*_{*nH*2} *> I*_{*nL*2} folgen, die parallel zueinander und antiparallel in Bezug auf den ersten Satz von Thyristoren (T_{L1} und T_{H1}) angeschlossen sind und jeweils eine Anode, eine Kathode und ein Gate umfassen, und wobei die Anoden an die zweite Klemme (B) angeschlossen sind,
iv) Auslösekreise (CD_{C1} und CD_{C2}), die jeweils an die Gates und Kathoden der Thyristoren mit niedrigerem Nennstrom (T_{L1} und T_{L2}) angeschlossen sind, um das Auslösen davon zu generieren,
v) eine Steuervorrichtung (CL), die an die Auslösekreise (CD_{C1} und CD_{C2}) angeschlossen ist,
vi) Dreiklemmenauslösekreise (CD₁ und CD₂), die das Auslösen der Thyristoren mit höherem Nennstrom (T_{H1} und T_{H2}) steuern und jeweils Folgendes umfassen:
i) erste Klemmen (tₐ₁ und tₐ₂), die jeweils an die Kathoden der Thyristoren mit niedrigerem Nennstrom (T_{L1} und T_{L2}) angeschlossen sind,
ii) zweite Klemmen (t_{b1} und t_{b2}), die jeweils an die Kathoden der Thyristoren mit höherem Nennstrom (T_{H1} und T_{H2}) angeschlossen sind, und
iii) dritte Klemmen (t_{c1} und t_{c2}), die an das Gate der Thyristoren mit höherem Nennstrom (T_{H1} und T_{H2}) angeschlossen sind,
wobei die Dreiklemmenauslösekreise (CD₁ und CD₂) zu Folgendem konfiguriert sind:
• wenn der durch den statischen Schalter fließende Strom niedriger ist als der Blockierstrom des Thyristors mit höherem Nennstrom (T_{H1}, T_{H2}), also *I* < *I*_{*lH*1}*, I*_{*lH*2}*,* Zulassen der Stromleitung durch die Thyristoren mit niedrigerem Nennstrom (T_{L1} und T_{L2}), wobei der Strom durch die dritten Klemmen (t_{c1} und t_{c2}) blockiert wird, wobei der Blockierstrom der Mindeststrom ist, der die Leitung des Thyristors aufrechterhalten könnte, und
• wenn der durch den statischen Schalter fließende Strom höher ist als der Blockierstrom des Thyristors mit höherem Nennstrom (T_{H1}, T_{H2}), also *I > I*_{*lH*1}, *I*_{*lH*2}*,* Versorgen des Gates des Thyristors mit höherem Nennstrom (T_{H1} und T_{H2}) über die dritte Klemme (t_{c1} und t_{c2}), wodurch das Auslösen des Thyristors bewirkt wird, wenn ein Gate-Strom (*I_{Gaux}*) des Thyristors mit höherem Nennstrom (T_{H1} und T_{H2}) und eine Gate-Kathoden-Spannung (*U_{Gaux}*) des Thyristors mit höherem Nennstrom (T_{H1} und T_{H2}) zwischen der dritten Klemme (t_{c1} und t_{c2}) und der zweiten Klemme (t_{b1} und t_{b2}) größer sind als die Gate-Spannungs- und Stromauslösewerte des Thyristors mit höherem Nennstrom (T_{H1} und T_{H2}); und sobald das Auslösen durchgeführt wurde, Zulassen der Stromleitung durch den Thyristor mit höherem Nennstrom (T_{H1} und T_{H2}) über die dritten Klemmen (t_{c1} und t_{c2}).

2. Statischer Schalter nach Anspruch 1, wobei jeder der Dreiklemmenauslösekreise (CD₁ und CD₂) Folgendes umfasst:
i) einen Kondensator (C₁), der zwischen der ersten Klemme (tₐ₁) und der zweiten Klemme (t_{b1}) angeschlossen ist,
ii) einen Widerstand (R_{c1}), der zwischen der ersten Klemme (tₐ₁) und der zweiten Klemme (t_{b1}) und parallel zum Kondensator (C₁) angeschlossen ist,
iii) einen Hilfsthyristor (Tₐᵤₓ₁), der zwischen der ersten Klemme (tₐ₁) und der dritten Klemme (t_{c1}) mit einem Serienwiderstand (R_{gH1}) angeschlossen ist,
iv) einen Spannungsteiler, umfassend Widerstände (Rₐ₁ und R_{b1}), die an das Gate des Hilfsthyristors (Tₐᵤₓ₁) und an die zweite Klemme (t_{b1}) angeschlossen sind,
v) eine Zenerdiode (D_{z1}), die zwischen der ersten Klemme (tₐ₁) und einem Mittelpunkt des Spannungsteilers angeschlossen ist.

## Revendications

1. Interrupteur statique de courant alternatif à plage d'intensité étendue, comprenant :
i) une première borne (A) et une seconde borne (B), destinées à être connectées à un quelconque circuit de courant alternatif externe dans lequel un contrôle de courant est nécessaire,
iii) un premier ensemble de deux thyristors (T_{L1} et T_{H1}) tels que les courants nominaux de ceux-ci suivent *I*_{*nH*1} *> I*_{*nL*1}*,* qui sont connectés en parallèle l'un à l'autre, comprenant chacun une anode, une cathode et une grille, les anodes étant connectées à la première borne (A),
iii) un second ensemble de deux thyristors (T_{L2} et T_{H2}) tels que les courants nominaux de ceux-ci suivent *I*_{*nH*2} *> I*_{*nL*2}, qui sont connectés en parallèle l'un à l'autre et en antiparallèle par rapport au premier ensemble de thyristors (T_{L1} et T_{H1}), comprenant chacun une anode, une cathode et une grille, et les anodes étant connectées à la deuxième borne (B),
iv) des circuits de déclenchement (CD_{C1} et CD_{C2}) connectés aux grilles et aux cathodes des thyristors avec un courant nominal plus faible (T_{L1} et T_{L2}) respectivement, pour générer leur déclenchement,
v) un dispositif de contrôle (CL) connecté aux circuits de déclenchement (CD_{C1} et CD_{C2}),
vi) des circuits de déclenchement tri-bornes (CD1 et CD2) qui gèrent le déclenchement des thyristors avec un courant nominal plus élevé, (T_{H1} et T_{H2}), et comprenant, respectivement :
i) des premières bornes (tₐ₁ et tₐ₂) connectées aux cathodes des thyristors avec un courant nominal plus faible (T_{L1} et T_{L2}) respectivement,
ii) des deuxièmes bornes (t_{b1} et t_{b2}) connectées aux cathodes des thyristors avec un courant nominal plus élevé (T_{H1} et T_{H2}), respectivement, et
iii) des troisièmes bornes (t_{c1} et t_{c2}) connectées à la grille des thyristors avec un courant nominal plus élevé (T_{H1} et T_{H2}),
dans lequel, les circuits de déclenchement tri-bornes (CD₁ et CD₂) sont configurés pour :
• lorsque le courant de circulation à travers l'interrupteur statique est plus faible que le courant de blocage du thyristor avec un courant nominal plus élevé (T_{H1}, T_{H2}), c'est-à-dire *I* < *I*_{*lH*1}*, l*_{*lH*2}, permettre la conduction de courant par les thyristors avec un courant nominal plus faible (T_{L1} et T_{L2}), bloquant le courant à travers les troisièmes bornes (t_{c1} et t_{c2}), dans lequel le courant de blocage est le courant minimum qui pourrait maintenir la conduction dudit thyristor, et
• lorsque le courant de circulation à travers l'interrupteur statique est plus élevé que le courant de blocage du thyristor avec un courant nominal plus élevé (T_{H1}, T_{H2}), c'est-à-dire *I > I*_{*lH*1}, *I*_{*lH*2}, alimenter la grille du thyristor avec un courant nominal plus élevé (T_{H1} et T_{H2}) à travers la troisième borne (t_{c1} et t_{c2}), provoquant le déclenchement dudit thyristor lorsqu'un courant de grille *(I_{Gaux})* du thyristor avec un courant nominal plus élevé (T_{H1} et T_{H2}) et une tension de cathode de grille *(U_{Gaux})* du thyristor avec un courant nominal plus élevé (T_{H1} et T_{H2}), entre la troisième borne (t_{c1} et t_{c2}) et la deuxième borne (t_{b1} et t_{b2}), sont supérieurs aux valeurs de déclenchement de la tension de grille et du courant du thyristor avec un courant nominal plus élevé (T_{H1} et T_{H2}) ; et une fois le déclenchement effectué, permettre la conduction de courant par le thyristor avec un courant nominal plus élevé (T_{H1} et T_{H2}) à travers les troisièmes bornes (t_{c1} et t_{c2}).

2. Interrupteur statique selon la revendication 1, dans lequel chacun des circuits de déclenchement tri-bornes (CD₁ et CD₂) comprend :
i) un condensateur (C₁), connecté entre la première borne (tₐ₁) et la deuxième borne (t_{b1}),
ii) une résistance (R_{c1}), connectée entre la première borne (tₐ₁) et la deuxième borne (t_{b1}) et en parallèle avec le condensateur (C₁),
iii) un thyristor auxiliaire (Tₐᵤₓ₁) connecté entre la première borne (tₐ₁) et la troisième borne (t_{c1}) avec une résistance en série (R_{gH1}),
iv) un diviseur de tension comprenant des résistances (Rₐ₁ et R_{b1}), connectées à la grille du thyristor auxiliaire (Tₐᵤₓ₁) et à la deuxième borne (t_{b1}),
v) une diode Zener (D_{z1}), connectée entre la première borne (tₐ₁) et un point médian du diviseur de tension.
